# EUROPEAN PATENT APPLICATION

(11) **EP 1 804 256 A1**
(43) Date of publication of application: **04.07.2007**
(21) Application number: 05782328.8
(22) Date of filing: 09.09.2005
(51) Int. Cl.: H01B 1/20, C08K 3/08, C08K 5/54, C08K 5/56, C08L 63/00, H05K 1/09

(54) **CONDUCTIVE PASTE AND FLEXIBLE PRINTED WIRING BOARD OBTAINED BY USING THE CONDUCTIVE PASTE**

(30) Priority: 10.09.2004 JP 2004264740
(71) Applicant: MITSUI MINING & SMELTING CO., LTD., Tokyo 141-8584 (JP)
(72) Inventor: KAMIKORIYAMA, Y., c/o MITSUI MIN. & SMELT. CO. LTD, Ageo-shi, Saitama 362-0021 (JP); ANAI, Kei, c/o MITSUI MIN. & SMELT. CO., LTD, Ageo-shi, Saitama 362-0021 (JP); OGATA, Sumikazu, c/o MITSUI MIN. & SMELT. CO., LTD, Ageo-shi, Saitama 362-0021 (JP)
(74) Representative: Bohmann, Armin K.
(86) International application number: PCT/JP2005/016607
(87) International publication number: WO 2006/028205

(57) **Abstract**

It is an object to provide a conductive paste which has not only sufficient adhesion to a polyimide as a substrate, but also good in both folding endurance and solvent resistance. To achieve the above object, the conductive paste comprises a conductive powder and a binder resin which is **characterized in that** the binder resin is an epoxy resin composition containing an aluminum compound and a silane coupling agent. The epoxy resin composition is preferred to contain the epoxy resin at 2 to 20 parts by weight, the aluminum compound at 0. 01 to 3.0 parts by weight and the silane coupling agent at 0.01 to 3.0 parts by weight.

## Description

### Technical Field

The present invention relates to a conductive paste and a flexible printed wiring board or the like produced using the conductive paste. In particular, the conductive paste according to the present invention is a conductive paste which has superior adhesion to a polyimide resin substrate.

### Background Art

Recently, because of requirement for miniaturization, down-sizing and integration on electronic/electric equipments, e.g., industrial electronic equipments, OA equipments and home electric appliances, they are adopting more multi-layered and higher density. Accordingly, printed circuits, e.g., flexible printed wiring (FPC) boards and membranes, which are widely used for these electronic/electric equipments, have become more multi-layered and higher density.

Tracing back the development history of printed wiring boards, the board material start with bakelite, and bisphenol type epoxy resins were widely used for circuit boards. The epoxy resins have advantages, e.g., high solubility in various solvents before being cured and high adhesion to copper foil or the like after being formed into a shape. However, the epoxy resins have several disadvantages, e.g., they have insufficient electrical characteristics when made into a thin film, and they are substantially inapplicable to a fabrication process involving folding and substantially impossible of being built in a narrow device space. So, polyimide resins have been thus employed as a material for circuit boards because they have a thermal expansion coefficient close to those of conductive metallic materials, e.g., copper, and can be folded in a device fabrication process or for use.

Beside, various methods for forming circuits on a printed wiring board are disclosed. Japanese Patent Application (Japanese Patent Laid-Open No. 5-95183) and a number of prior art documents disclose the method that a copper foil laminated on a board is etched. Japanese Patent Application (Japanese Patent Laid-Open No. 8-18190) and Japanese Patent Application (Japanese Patent Laid-Open No. 2004-247572) disclose the methods that a circuit shape is directly formed on the surface of a board with a conductive paste by screen printing or spraying through a nozzle, and then heated and cured to obtain a circuit.

It is well known that it is very difficult to form a circuit shape on a polyimide resin substrate by screen printing or the like with a conductive paste, because of insufficiency in both wettability with polyimide and flatness/smoothness of the paste. Moreover, fine wirings, even when formed with a conductive paste, involve several problems, e.g., separation of wirings from the board in a subsequent step, e.g., rinsing, because of its insufficient adhesion to polyimide. Such problems make a conductive paste impractical. Still more, for solvent resistance and folding endurance are required when used for printing on a circuit board of polyimide or the like.

Several methods have been proposed to solve these problems as followings. Japanese Patent Application (Japanese Patent Laid-Open No. 2004-221006) disclose the method to produce a polyimide and/or polyamide by co-polymerization with one or more components, e.g., rubber (e.g., butadiene rubber) or polyester as a binder resin for a conductive paste. Japanese Patent Application (Japanese Patent Laid-Open No. H8-120200) disclose the method to adopt a conductive paste composition comprising a specific soluble polyimide siloxane, an epoxy resin, a metal powder and a soluble organic solvent.

[Patent Document 1] : Japanese Patent Application (Japanese Patent Laid-Open No. H5-95183)
[Patent Document 2] : Japanese Patent Application (Japanese Patent Laid-Open No. H8-18190)
[Patent Document 3] : Japanese Patent Application (Japanese Patent Laid-Open No. 2004-247572)
[Patent Document 4] : Japanese Patent Application (Japanese Patent Laid-Open No. 2004-221006)
[Patent Document 5] : Japanese Patent Application (Japanese Patent Laid-Open No. H8-120200)

### Disclosure of the Invention

However, the inventions disclosed in Japanese Patent Laid-Open No. 2004-221006 and Japanese Patent Laid-Open No. H8-120200, which attempt to solve the above problems by selecting a binder resin for a conductive paste, fail to provide practically sufficient adhesion to a polyimide as a substrate.

Therefore, it is an object of the present invention to provide a conductive paste which has not only sufficient adhesion to a polyimide as a substrate, but also good in both folding endurance and solvent resistance.

The inventors of the present invention have found after extensive study to solve the above problems that above object can be achieved by using an epoxy resin composition as a binder resin which contains an aluminum compound and silane coupling agent for a conductive paste, then the present invention is achieved.

Conductive paste of the present invention: The conductive paste of the present invention comprises a conductive powder and a binder resin, and it is characterized in that the binder resin is an epoxy resin composition containing an aluminum compound and a silane coupling agent. When the epoxy resin composition contains an epoxy resin as a major component and an aluminum compound and silane coupling agent as a supporting components as a binder resin is used for production of a conductive paste, it can provide a conductive paste which is superior in both wettability and adhesion to a polyimide resin substrate.

The epoxy resin composition is preferred to have a basic composition containing the epoxy resin at 2 to 20 parts by weight, the aluminum compound at 0.01 to 3.0 parts by weight and the silane coupling agent at 0.01 to 3.0 parts by weight.

The aluminum compound is preferred to be one or mixture selected from the group consisting of aluminum alkyl acetate diisopropylate, aluminum tris(acetylacetonate), aluminum bis (ethylacetoacetate)mono(acetylacetonate), aluminum ethylacetoacetate diisopropylate, aluminum tris (ethylacetoacetate), aluminum oxide isopropoxide polymer, aluminum oxide octylate trimer, aluminum oxide stearate trimer, aluminum oxide laurate trimer, aluminum ethylate, aluminum isopropylate, aluminum isopropylate mono-secondary butylate and aluminum secondary butylate.

The silane coupling agent is preferred to be one or mixture selected from the group consisting of epoxy-functional silane coupling agents, amine-functional silane coupling agents, styryl-functional silane coupling agents, methacryloxy-functional silane coupling agents, acryloxy-functional silane coupling agents and vinyl-functional silane coupling agents.

The conductive powder can be selected from the group consisting of powders of gold, silver, copper, tin, platinum, nickel, palladium, aluminum, and alloys thereof, and carbon and metal oxides.

The conductive paste of the present invention is preferred to contain the conductive powder at 50 to 90% by weight, and the balance is the binder resin.

Flexible printed wiring board of the present invention: A circuit formed on a polyimide resin substrate by the conductive paste is superior in adhesion to the polyimide resin substrate. The conductive paste allows a circuit to be directly formed on the surface of a polyimide resin substrate by screen printing or dispenser-aided coating without causing any practical problems.

The conductive paste of the present invention is superior in adhesion to a polyimide resin substrate, and has characteristics which a conductive paste is required to have, e.g., folding endurance and solvent resistance. Accordingly, the conductive paste of the present invention allows a circuit directly formed on the surface of a polyimide resin substrate by screen printing or dispenser-aided coating to have superior adhesion, and greatly reduces flexible printed wiring board production processes and hence production cost.

### Best Mode for Carrying Out the Invention

### (Conductive paste of the present invention)

Embodiments of the conductive paste of the present invention are described. The conductive paste of the present invention comprises a conductive powder and a binder resin, wherein the binder resin is an epoxy resin composition containing an aluminum compound and a silane coupling agent.

Epoxy resin: The epoxy resin for the epoxy resin composition is preferably in the form of liquid or powder having an epoxy equivalent of 100 to 1000 and a molecular weight of 400 to 5000. More specifically, the preferable epoxy resins include novolac type epoxy resins, bisphenol A type epoxy resins, bisphenol F type epoxy resins and glycidyl amine-type multifunctional epoxy resins can be shown as an example. Among them, bisphenol F type epoxy resin can be preferably used in particular.

The epoxy resin is blended in the epoxy resin composition preferably at 2 to 20 parts by weight. At below 2 parts by weight, the resin composition may be out of a well balanced range to assure good adhesion to a polyimide resin substrate. At above 20 parts by weight, on the other hand, it may make the conductive paste difficult to assure desired electro-conductivity after curing, because of excessively increased electrical resistance of the electrode or wiring formed. It is more preferable to be blended at 4 to 10 parts by weight. At 4 parts by weight or more, it can assure good adhesion to a polyimide resin substrate more stably. At 10 parts by weight or less, it can assure still higher electro-conductivity.

Aluminum compound: For the aluminum compound as one component of the epoxy resin composition, aluminum alkyl acetate diisopropylate, aluminum tris(acetylacetonate), aluminum-bis(ethylacetoacetate)mono(acetylacetonate), aluminum ethylacetoacetate diisopropylate, aluminum tris (ethylacetoacetate), aluminum oxide isopropoxide polymer, aluminum oxide octylate trimer, aluminum oxide stearate trimer, aluminum oxide laurate trimer, aluminum ethylate, aluminum isopropylate, aluminum isopropylate mono-secondary butylate and aluminum secondary butylate and the like can be selected. The aluminum compound works as a supporting component to improve adhesion of the epoxy resin composition to a polyimide resin substrate. Of these aluminum compounds, aluminum alkyl acetate diisopropylate exhibits superior stability in properties in particular.

The aluminum compound blended in the epoxy resin composition is preferably at 0.01 to 3.0 parts by weight. At below 0.01 parts by weight, it may fail both to improve adhesion of the epoxy resin composition to a polyimide resin substrate and to maintain adhesion of a circuit after heating. At above 3.0 parts by weight, on the other hand, it may make the resin brittle when cured to form a circuit, and also fail to provide a flexible printed wiring board having a sufficient toughness. It is more preferable to be blended at 0.05 to 1.0 parts by weight. The epoxy resin composition, when blended with the aluminum compound at content in the above range, it can assure its adhesion to a polyimide resin substrate and flexibility of cured circuit most effectively and stably.

Silane coupling agent: The silane coupling agent is blended in the epoxy resin composition to improve wettability of the binder resin with particles of the conductive powder thereby improving dispersibility of the conductive particles in the resin composition and, at the same time, improve adhesion of the cured binder resin of the epoxy resin composition to a polyimide resin substrate. The useful silane coupling agents include vinyl methoxysilane, vinyl ethoxysilane, γ-chloropropyl trimethoxysilane, γ-aminopropyl trimethoxysilane, γ-aminopropyl triethoxysilane, N-(β-aminoethyl) -γ-aminopropyl trimethoxysilane, N-(β-aminoethyl) -γ-aminopropyl methyldimethoxysilane, γ-glycidoxypropyl trimethoxysilane, β-(3,4-epoxy cyclohexyl) ethyltrimethoxysilane, γ-methacryloxypropyl trimethoxysilane, γ-methacryloxypropyl methyldimethoxysilane, γ-mercaptopropyl trimethoxysilane and hexamethyl disilazane. Of these, more preferable are γ-aminopropyl triethoxysilane, N-(β-aminoethyl) -γ-aminopropyl trimethoxysilane, N-(β-aminoethyl)-γ-aminopropyl methyldimethoxysilane, γ-glycidoxypropyl trimethoxysilane and β-glycidoxypropyl methyldimethoxysilane as amino- or epoxy-based silane coupling agents.

The silane coupling agent is blended in the epoxy resin composition preferably at 0.01 to 3.0 parts by weight, more preferably 0.05 to 1.0 parts by weight. At below 0.01 parts by weight, it may fail to improve all wettability of the binder resin to particles of the conductive powder, dispersibility of the conductive particles, and adhesion of the cured binder resin of the epoxy resin composition to a polyimide resin substrate. At above 3.0 parts by weight, on the other hand, it may no longer further improve wettability of the binder resin to particles of the conductive powder, dispersibility of the conductive particles, or adhesion of the cured binder resin containing the epoxy resin composition to a polyimide resin substrate. And it also may have an off-balance viscosity of the epoxy resin composition and cause wasteful consumption of resources.

Optional components of the epoxy resin composition: The epoxy resin composition for the present invention may be blended with various additives, as required for specific purposes, e.g., dilution solvent, curing agent, viscosity adjustor, oxidation inhibitor, flame retardant, filler, pigment, dye, surfactant, antistatic agent, de-foaming agent and so forth.

When the conductive paste of the present invention is used to form a circuit shape on a polyimide resin, it may be mixed with an organic solvent to adjust its viscosity by adjusting its solid content. The useful organic solvents include alcohol-based solvents, e.g., n-butyl alcohol, ethylene glycol, 2-methoxy ethanol, 4-methyl-2-pentanol, diacetone alcohol, terpineol and 2-n-butoxy ethanol; amide-based solvents, e.g., N,N-dimethylacetoamide, N,N-diethylacetoamide, N,N-dimethylformamide, N,N-diethylformamide and N-methyl-2-pyrrolidone; sulfur-based solvents, e.g., dimethyl sulfoxide, diethyl sulfoxide, dimethyl sulfone, diethyl sulfone and hexamethylsulfonamide; phenol-based solvents, e.g., cresol, phenol and xylenol; ketone-based solvents, e.g., cyclohexanone and methylethylketone; and nitrile-based solvents, e.g., acetonitrile and propionitrile. These solvents may be used either individually or in combination as a mixture.

Conductive powder: Conductive powders useful for the conductive paste of the present invention include those of gold, silver, copper, tin, platinum, nickel, palladium, aluminum, and alloys thereof, and carbon (e.g., carbon black and graphite) and metal oxides. Of these, copper powders and silver powders are particularly preferable, because they can derive finer particles.

The conductive powder shape is not limited, and any shape can be used. For example, it may be spherical, flaky, dendrite-shaped, spindle-shaped, agglomerated or indefinite.

Content of conductive powder in the conductive paste: The conductive paste of the present invention is preferred to have a composition containing the conductive powder described above at 50 to 90% by weight, and the balance is the binder resin. Fundamentally, the conductive paste is designed to contain the conductive powder at an adequate content which varies depending on specific purposes of the paste. Accordingly, the conductive powder content is not limited. However, based on the assumption that the conductive paste is used to give conductibity to an electric circuit or the like, it may have an insufficient filling density after being cured when it contains the conductive powder at below 50% by weight. Even how the powder is composed of fine particles highly dispersible and difficult to agglomerate, it makes the paste unsuitable for forming an electric circuit, because resistance of the thin paste film increases. At above 90% by weight, on the other hand, viscosity of the conductive paste may excessively increase to make the paste difficult to handle and cause troubles, e.g., screen clogging.

Production of the conductive paste of the present invention: The method for producing the conductive paste of the present invention is not limited. It may be adequately produced by an emperor type dispersing machine (e.g., dissolver), 3-roll mill, sand mill, ball mill, bead mill or the like.
The present invention is described more specifically by Example described below or the like.

### Example 1

A basic composition was prepared by blending 7.05 g (4.74 parts by weight) of bisphenol F type epoxy resin (RE303SL, Nippon Kayaku), 0.15 g (0.10 parts by weight) of an aluminum compound (Plenact ALM, Kawaken Fine Chemicals Co., Ltd.), and 0.08 g each of silane coupling agents (KBM303 and KBM 403, 0.076 g × 2 = 0.10 parts by weight, both of Shin-Etsu Chemical Co., Ltd.). The basic composition was blended with 1.64 g of an anhydrous acid type hardening agent (Kayahard MCD, Nippon Kayaku Co., Ltd.), 0.43 g of an amine adduct type hardening agent (Amicure MY-24, Ajinomoto Fine-Techno Co., Inc.), 0.45 g of ethyl cellulose (Wako Pure Chemical Industries, Ltd.), 0.27 g of silicone (X-22-169-AS, Shin-Etsu Chemical Co., Ltd.), 17.5 g of Terpineol C (Nippon Terpene Chemicals, Inc.) as a viscosity adjustor and 1.2 g of aerosil (Aerosil 200V, Nippon Aerosil Co., Ltd.), and kneaded by a paddle type kneader. The resulting mixture was blended with spherical and super-thin flaky silver powder, and further kneaded.

Then, the resulting mixture was kneaded by a 3-roll mill and treated by a de-foaming machine (AR250, THINKY Corporation) to remove bubbles from the mixture to prepare a silver paste. The silver paste contained the fine spherical silver powder at 56.43% by weight, and the super-thin flaky silver powder at 24.19% by weight.

The silver paste thus obtained was printed on a polyimide resin substrate by a screen printer to form a wiring of width at 50 µm and a space between wiring at 50 µm. It showed good printability, because neither wiring disconnection nor paste bleeding was observed. It was confirmed that the screen set in the screen printer get no clogging with the silver powder from examination by microscopic observation.

The silver paste was printed in 3 cm width and 3 cm length on a polyimide resin substrate by a screen printer and dried at 180° C for 1 hour to prepare a sample for an adhesion test. A cross-cut tape peeling test was performed to examine adhesion of the dried film to polyimide. It was confirmed that the paste was well adhered to the polyimide resin substrate, because no peeling off of the paste was observed in any grid section.

In addition, the silver paste was printed in 3 cm width and 3 cm length on a polyimide resin substrate by a screen printer and dried at 180 °C for 1 hour to prepare a sample for resistivity measurement. Thickness of the dried film was measured by a digital film thickness meter to calculate resistivity. Resistivity was 5.781 × 10⁻⁴ Ω·cm.

### Industrial Applicability

The conductive paste of the present invention is superior in adhesion to a polyimide resin substrate, and has characteristics which a conductive paste is required to have, e.g., folding endurance and solvent resistance, for forming circuits. Accordingly, it is suitably used for producing printed wiring boards, including flexible printed wiring boards.

## Claims

1. A conductive paste comprising a conductive powder and a binder resin, which is **characterized in that** the binder resin is an epoxy resin composition containing an aluminum compound and a silane coupling agent.

2. The conductive paste according to Claim 1, wherein the epoxy resin composition contains the epoxy resin at 2 to 20 parts by weight, the aluminum compound at 0.01 to 3.0 parts by weight and the silane coupling agent at 0.01 to 3.0 parts by weight.

3. The conductive paste according to Claims 1 or 2, wherein the aluminum compound is at least one or mixture selected from the group consisting of aluminum alkyl acetate diisopropylate, aluminum tris(acetylacetonate), aluminum-bis (ethylacetoacetate)mono(acetylacetonate), aluminum ethylacetoacetate diisopropylate, aluminum tris (ethylacetoacetate), aluminum oxide isopropoxide polymer, aluminum oxide octylate trimer, aluminum oxide stearate trimer, aluminum oxide laurate trimer, aluminum ethylate, aluminum isopropylate, aluminum isopropylate mono-secondary butylate and aluminum secondary butylate.

4. The conductive paste according to any of Claims 1 to 3, wherein the silane coupling agent is at least one or mixture selected from the group consisting of epoxy-functional silane coupling agents, amine-functional silane coupling agents, styryl-functional silane coupling agents, methacryloxy-functional silane coupling agents, acryloxy-functional silane coupling agents and vinyl-functional silane coupling agents.

5. The conductive paste according to any of Claims 1 to 4, wherein the conductive powder is selected from the group consisting of powders of gold, silver, copper, tin, platinum, nickel, palladium, aluminum, and alloys thereof, and carbon and metal oxides.

6. The conductive paste according to any of Claims 1 to 5 which contains the conductive powder at 50 to 90% by weight, and the balance is the binder resin.

7. A flexible printed wiring board comprising a polyimide resin substrate on which a circuit is formed by using the conductive paste according to any of Claims 1 to 6.
